# EUROPEAN PATENT APPLICATION

(11) **EP 4 170 430 A1**
(43) Date of publication of application: **26.04.2023**
(21) Application number: 21204377.2
(22) Date of filing: 25.10.2021
(51) Int. Cl.: G03F 7/20

(54) **METROLOGY APPARATUS AND METROLOGY METHODS BASED ON HIGH HARMONIC GENERATION FROM A DIFFRACTIVE STRUCTURE**

(71) Applicant: ASML Netherlands B.V., 5500 AH Veldhoven (NL)
(72) Inventor: MAAS, Diederik, 5500 AH Veldhoven (NL); OP 'T ROOT, Wilhelmus, Patrick, Elisabeth, Maria, 5500 AH Veldhoven (NL); JOCHEMSEN, Marinus, 5500 AH Veldhoven (NL); CRAMER, Hugo, Augustinus Joseph, 5500 AH Veldhoven (NL)
(74) Representative: ASML Netherlands B.V.

(57) **Abstract**

Disclosed is metrology apparatus for measurement of a diffractive structure on a substrate, comprising:
a radiation source operable to provide first radiation for excitation of the diffractive structure, said first radiation having a first wavelength; a detection arrangement operable to detect at least diffracted second radiation comprising a second harmonic of said first radiation, said diffracted second radiation being generated from said diffractive structure and/or substrate and diffracted by said diffractive structure; and a processing arrangement operable to determine a parameter of interest relating to said diffractive structure from at least said diffracted second radiation.

## Description

### FIELD

The present invention relates to methods and apparatus for metrology usable, for example, in the manufacture of devices by lithographic techniques.

### BACKGROUND

A lithographic apparatus is a machine constructed to apply a desired pattern onto a substrate. A lithographic apparatus can be used, for example, in the manufacture of integrated circuits (ICs). A lithographic apparatus may, for example, project a pattern (also often referred to as "design layout" or "design") at a patterning device (e.g., a mask) onto a layer of radiation-sensitive material (resist) provided on a substrate (e.g., a wafer).

To project a pattern on a substrate a lithographic apparatus may use electromagnetic radiation. The wavelength of this radiation determines the minimum size of features which can be formed on the substrate. Typical wavelengths currently in use are 365 nm (i-line), 248 nm, 193 nm and 13.5 nm. A lithographic apparatus, which uses extreme ultraviolet (EUV) radiation, Such an apparatus may use a wavelength within the range 4-20 nm, for example 6.7 nm or 13.5 nm, to form smaller features on a substrate than a lithographic apparatus which uses, for example, radiation with a wavelength of 193 nm.

Low-ki lithography may be used to process features with dimensions smaller than the classical resolution limit of a lithographic apparatus. In such process, the resolution formula may be expressed as CD = k₁×λ/NA, where λ is the wavelength of radiation employed, NA is the numerical aperture of the projection optics in the lithographic apparatus, CD is the "critical dimension" (generally the smallest feature size printed, but in this case half-pitch) and ki is an empirical resolution factor. In general, the smaller ki the more difficult it becomes to reproduce the pattern on the substrate that resembles the shape and dimensions planned by a circuit designer in order to achieve particular electrical functionality and performance. To overcome these difficulties, sophisticated fine-tuning steps may be applied to the lithographic projection apparatus and/or design layout. These include, for example, but not limited to, optimization of NA, customized illumination schemes, use of phase shifting patterning devices, various optimization of the design layout such as optical proximity correction (OPC, sometimes also referred to as "optical and process correction") in the design layout, or other methods generally defined as "resolution enhancement techniques" (RET). Alternatively, tight control loops for controlling a stability of the lithographic apparatus may be used to improve reproduction of the pattern at low k1.

In lithographic processes, it is desirable frequently to make measurements of the structures created, e.g., for process control and verification. Various tools for making such measurements are known, including scanning electron microscopes, which are often used to measure critical dimension (CD), and specialized tools to measure overlay, the accuracy of alignment of two layers in a device. Recently, various forms of scatterometers have been developed for use in the lithographic field.

Examples of known scatterometers often rely on provision of dedicated metrology targets. For example, a method may require a target in the form of a simple grating that is large enough that a measurement beam generates a spot that is smaller than the grating (i.e., the grating is underfilled). In so-called reconstruction methods, properties of the grating can be calculated by simulating interaction of scattered radiation with a mathematical model of the target structure. Parameters of the model are adjusted until the simulated interaction produces a diffraction pattern similar to that observed from the real target.

In addition to measurement of feature shapes by reconstruction, diffraction-based overlay can be measured using such apparatus, as described in published patent application US2006066855A1. Diffraction-based overlay metrology using dark-field imaging of the diffraction orders enables overlay measurements on smaller targets. These targets can be smaller than the illumination spot and may be surrounded by product structures on a wafer. Examples of dark field imaging metrology can be found in numerous published patent applications, such as for example US2011102753A1 and US20120044470A. Multiple gratings can be measured in one image, using a composite grating target.

An issue with these types of metrology techniques is that of ghost images caused by reflections off the complex optics within the metrology tools used, which typically has many (uncoated) surfaces. These ghost images result in a reduced signal-to-noise ratio of the measurement signal. Another cause of a reduced signal-to-noise ratio is the shrinking of resist layer thickness on many substrates, particularly if exposed using SXR or EUV radiation. The diffraction signal weakens as bulk interaction volume shrinks.

It would be desirable to address at least one of these issues.

### SUMMARY

In a first aspect of the invention, there is provided a metrology apparatus for measurement of a diffractive structure on a substrate, comprising: a radiation source operable to provide first radiation for excitation of the diffractive structure, said first radiation having a first wavelength; a detection arrangement operable to detect at least diffracted second radiation comprising a second harmonic of said first radiation, said diffracted second radiation being generated from said diffractive structure and/or substrate and diffracted by said diffractive structure; and a processing arrangement operable to determine a parameter of interest relating to said diffractive structure from at least said diffracted second radiation.

In a second aspect of the invention, there is provided a metrology apparatus for measurement of a diffractive structure on a substrate, comprising: a radiation source operable to provide first radiation for excitation of the diffractive structure, said first radiation having a first wavelength; a wavelength separation or filtering arrangement operable to separate or filter out scattered first radiation from diffracted second radiation comprising a higher harmonic of said first radiation, wherein said diffracted second radiation is generated from said diffractive structure and/or substrate and diffracted by said diffractive structure and said scattered first radiation has been scattered and/or diffracted from said diffractive structure and comprises said first wavelength;
a detection arrangement operable to detect at least said diffracted second radiation; and a processing arrangement operable to determine a parameter of interest relating to said diffractive structure from at least said diffracted second radiation.

In a third aspect of the invention, there is provided a method of measurement of a diffractive structure on a substrate, comprising: exciting the diffractive structure with first radiation having a first wavelength thereby generating second radiation comprising a second harmonic of said first radiation from said diffractive structure, said second radiation further diffracting from said diffractive structure to form diffracted second radiation; detecting at least said diffracted second radiation; and determining a parameter of interest relating to said diffractive structure from at least said diffracted second radiation.

In a fourth aspect of the invention, there is provided a method of measurement of a diffractive structure on a substrate, comprising: exciting the diffractive structure with first radiation having a first wavelength thereby generating second radiation comprising a higher harmonic of said first radiation from said diffractive structure, said second radiation further diffracting from said diffractive structure to form diffracted second radiation; separating said diffracted second radiation from scattered first radiation having been scattered by said diffractive structure;
detecting at least said diffracted second radiation; and determining a parameter of interest relating to said diffractive structure from at least said diffracted second radiation.

### BRIEF DESCRIPTION OF THE DRAWINGS

Embodiments will now be described, by way of example only, with reference to the accompanying schematic drawings, in which:
- Figure 1 depicts a schematic overview of a lithographic apparatus;
- Figure 2 depicts a schematic overview of a lithographic cell;
- Figure 3 depicts a schematic representation of holistic lithography, representing a cooperation between three key technologies to optimize semiconductor manufacturing;
- Figure 4 schematically illustrates a scatterometry apparatus, adaptable using concepts disclosed herein;
- Figure 5 comprises (a) a schematic diagram of a dark field scatterometer for use in measuring targets according to embodiments of the invention using a first pair of illumination apertures, (b) a detail of diffraction spectrum of a target grating for a given direction of illumination;
- Figure 6 depicts a schematic representation of a radiation source usable in an embodiment for providing broadband output radiation;
- Figure 7 schematically depicts the concept of diffractive high harmonic generation from a metrology target;
- Figure 8 schematically depicts a metrology apparatus which uses diffractive high harmonic generation from the target according to an embodiment; and
- Figure 9 schematically depicts a wavelength separation arrangement usable in the metrology apparatus of Figure 8, according to an embodiment.

### DETAILED DESCRIPTION

In the present document, the terms "radiation" and "beam" are used to encompass all types of electromagnetic radiation and particle radiation, including ultraviolet radiation (e.g. with a wavelength of 365, 248, 193, 157 or 126 nm), EUV (extreme ultra-violet radiation, e.g. having a wavelength in the range of about 5-125 nm or 5 to 100nm), X-ray radiation, electron beam radiation and other particle radiation.

The term "reticle", "mask" or "patterning device" as employed in this text may be broadly interpreted as referring to a generic patterning device that can be used to endow an incoming radiation beam with a patterned cross-section, corresponding to a pattern that is to be created in a target portion of the substrate. The term "light valve" can also be used in this context. Besides the classic mask (transmissive or reflective, binary, phase-shifting, hybrid, etc.), examples of other such patterning devices include a programmable mirror array and a programmable LCD array.

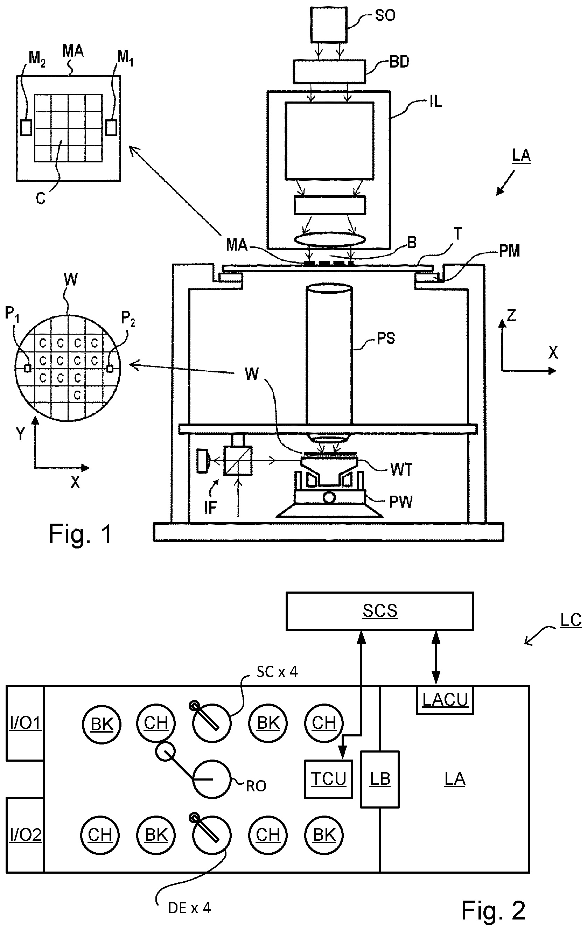

Figure 1 schematically depicts a lithographic apparatus LA. The lithographic apparatus LA includes an illumination system (also referred to as illuminator) IL configured to condition a radiation beam B (e.g., UV radiation, DUV radiation, EUV radiation or X-ray radiation), a mask support (e.g., a mask table) T constructed to support a patterning device (e.g., a mask) MA and connected to a first positioner PM configured to accurately position the patterning device MA in accordance with certain parameters, a substrate support (e.g., a wafer table) WT constructed to hold a substrate (e.g., a resist coated wafer) W and connected to a second positioner PW configured to accurately position the substrate support in accordance with certain parameters, and a projection system (e.g., a refractive projection lens system) PS configured to project a pattern imparted to the radiation beam B by patterning device MA onto a target portion C (e.g., comprising one or more dies) of the substrate W.

In operation, the illumination system IL receives a radiation beam from a radiation source SO, e.g. via a beam delivery system BD. The illumination system IL may include various types of optical components, such as refractive, reflective, diffractive, magnetic, electromagnetic, electrostatic, and/or other types of optical components, or any combination thereof, for directing, shaping, and/or controlling radiation. The illuminator IL may be used to condition the radiation beam B to have a desired spatial and angular intensity distribution in its cross section at a plane of the patterning device MA.

The term "projection system" PS used herein should be broadly interpreted as encompassing various types of projection system, including refractive, reflective, diffractive, catadioptric, anamorphic, magnetic, electromagnetic and/or electrostatic optical systems, or any combination thereof, as appropriate for the exposure radiation being used, and/or for other factors such as the use of an immersion liquid or the use of a vacuum. Any use of the term "projection lens" herein may be considered as synonymous with the more general term "projection system" PS.

The lithographic apparatus LA may be of a type wherein at least a portion of the substrate may be covered by a liquid having a relatively high refractive index, e.g., water, so as to fill a space between the projection system PS and the substrate W - which is also referred to as immersion lithography. More information on immersion techniques is given in US6952253, which is incorporated herein by reference in its entirety.

The lithographic apparatus LA may also be of a type having two or more substrate supports WT (also named "dual stage"). In such "multiple stage" machine, the substrate supports WT may be used in parallel, and/or steps in preparation of a subsequent exposure of the substrate W may be carried out on the substrate W located on one of the substrate support WT while another substrate W on the other substrate support WT is being used for exposing a pattern on the other substrate W.

In addition to the substrate support WT, the lithographic apparatus LA may comprise a measurement stage. The measurement stage is arranged to hold a sensor and/or a cleaning device. The sensor may be arranged to measure a property of the projection system PS or a property of the radiation beam B. The measurement stage may hold multiple sensors. The cleaning device may be arranged to clean part of the lithographic apparatus, for example a part of the projection system PS or a part of a system that provides the immersion liquid. The measurement stage may move beneath the projection system PS when the substrate support WT is away from the projection system PS.

In operation, the radiation beam B is incident on the patterning device, e.g. mask, MA which is held on the mask support T, and is patterned by the pattern (design layout) present on patterning device MA. Having traversed the mask MA, the radiation beam B passes through the projection system PS, which focuses the beam onto a target portion C of the substrate W. With the aid of the second positioner PW and a position measurement system IF, the substrate support WT may be moved accurately, e.g., so as to position different target portions C in the path of the radiation beam B at a focused and aligned position. Similarly, the first positioner PM and possibly another position sensor (which is not explicitly depicted in Figure 1) may be used to accurately position the patterning device MA with respect to the path of the radiation beam B. Patterning device MA and substrate W may be aligned using mask alignment marks M1, M2 and substrate alignment marks PI, P2. Although the substrate alignment marks PI, P2 as illustrated occupy dedicated target portions, they may be located in spaces between target portions. Substrate alignment marks PI, P2 are known as scribe-lane alignment marks when these are located between the target portions C.

As shown in Figure 2 the lithographic apparatus LA may form part of a lithographic cell LC, also sometimes referred to as a lithocell or (litho)cluster, which often also includes apparatus to perform preand post-exposure processes on a substrate W. Conventionally these include spin coaters SC to deposit resist layers, developers DE to develop exposed resist, chill plates CH and bake plates BK, e.g. for conditioning the temperature of substrates W e.g. for conditioning solvents in the resist layers. A substrate handler, or robot, RO picks up substrates W from input/output ports I/O1, I/O2, moves them between the different process apparatus and delivers the substrates W to the loading bay LB of the lithographic apparatus LA. The devices in the lithocell, which are often also collectively referred to as the track, may be under the control of a track control unit TCU that in itself may be controlled by a supervisory control system SCS, which may also control the lithographic apparatus LA, e.g. via lithography control unit LACU.

In lithographic processes, it is desirable to make frequently measurements of the structures created, e.g., for process control and verification. Tools to make such measurement may be called metrology tools MT. Different types of metrology tools MT for making such measurements are known, including scanning electron microscopes or various forms of scatterometer metrology tools MT. Scatterometers are versatile instruments which allow measurements of the parameters of a lithographic process by having a sensor in the pupil or a conjugate plane with the pupil of the objective of the scatterometer, measurements usually referred as pupil based measurements, or by having the sensor in an image plane or a plane conjugate with the image plane, in which case the measurements are usually referred as image or field based measurements. Such scatterometers and the associated measurement techniques are further described in patent applications US20100328655, US2011102753A1, US20120044470A, US20110249244, US20110026032 or EP1,628,164A, incorporated herein by reference in their entirety. Aforementioned scatterometers may measure gratings using light from hard X-ray, soft X-ray, extreme ultraviolet and visible to near-IR wavelength range. In case that the radiation is hard X-ray or soft X-ray, optionally with a wavelength ranging from 0.01 to 10 nm, the aforementioned scatterometers may optionally be a small-angle X-ray scattering metrology tool.

In order for the substrates W exposed by the lithographic apparatus LA to be exposed correctly and consistently, it is desirable to inspect substrates to measure properties of patterned structures, such as overlay errors between subsequent layers, line thicknesses, critical dimensions (CD), shape of structures, etc. For this purpose, inspection tools and/or metrology tools (not shown) may be included in the lithocell LC. If errors are detected, adjustments, for example, may be made to exposures of subsequent substrates or to other processing steps that are to be performed on the substrates W, especially if the inspection is done before other substrates W of the same batch or lot are still to be exposed or processed.

An inspection apparatus, which may also be referred to as a metrology apparatus, is used to determine properties of the substrates W, and in particular, how properties of different substrates W vary or how properties associated with different layers of the same substrate W vary from layer to layer. The inspection apparatus may alternatively be constructed to identify defects on the substrate W and may, for example, be part of the lithocell LC, or may be integrated into the lithographic apparatus LA, or may even be a stand-alone device. The inspection apparatus may measure the properties on a latent image (image in a resist layer after the exposure), or on a semi-latent image (image in a resist layer after a post-exposure bake step PEB), or on a developed resist image (in which the exposed or unexposed parts of the resist have been removed), or even on an etched image (after a pattern transfer step such as etching).

In a first embodiment, the scatterometer MT is an angular resolved scatterometer. In such a scatterometer reconstruction methods may be applied to the measured signal to reconstruct or calculate properties of the grating. Such reconstruction may, for example, result from simulating interaction of scattered radiation with a mathematical model of the target structure and comparing the simulation results with those of a measurement. Parameters of the mathematical model are adjusted until the simulated interaction produces a diffraction pattern similar to that observed from the real target.

In a second embodiment, the scatterometer MT is a spectroscopic scatterometer MT. In such spectroscopic scatterometer MT, the radiation emitted by a radiation source is directed onto the target and the reflected, transmitted or scattered radiation from the target is directed to a spectrometer detector, which measures a spectrum (i.e. a measurement of intensity as a function of wavelength) of the specular reflected radiation. From this data, the structure or profile of the target giving rise to the detected spectrum may be reconstructed, e.g. by Rigorous Coupled Wave Analysis and non-linear regression or by comparison with a library of simulated spectra.

In a third embodiment, the scatterometer MT is an ellipsometric scatterometer. The ellipsometric scatterometer allows for determining parameters of a lithographic process by measuring scattered or transmitted radiation for each polarization states. Such metrology apparatus emits polarized light (such as linear, circular, or elliptic) by using, for example, appropriate polarization filters in the illumination section of the metrology apparatus. A source suitable for the metrology apparatus may provide polarized radiation as well. Various embodiments of existing ellipsometric scatterometers are described in US patent applications 11/451,599, 11/708,678, 12/256,780, 12/486,449, 12/920,968, 12/922,587, 13/000,229, 13/033,135, 13/533,110 and 13/891,410 incorporated herein by reference in their entirety.

In one embodiment of the scatterometer MT, the scatterometer MT is adapted to measure the overlay of two misaligned gratings or periodic structures by measuring asymmetry in the reflected spectrum and/or the detection configuration, the asymmetry being related to the extent of the overlay. The two (maybe overlapping) grating structures may be applied in two different layers (not necessarily consecutive layers), and may be formed substantially at the same position on the wafer. The scatterometer may have a symmetrical detection configuration as described e.g. in co-owned patent application EP1,628,164A, such that any asymmetry is clearly distinguishable. This provides a straightforward way to measure misalignment in gratings. Further examples for measuring overlay error between the two layers containing periodic structures as target is measured through asymmetry of the periodic structures may be found in PCT patent application publication no. WO 2011/012624 or US patent application US 20160161863, incorporated herein by reference in its entirety.

Other parameters of interest may be focus and dose. Focus and dose may be determined simultaneously by scatterometry (or alternatively by scanning electron microscopy) as described in US patent application US2011-0249244, incorporated herein by reference in its entirety. A single structure may be used which has a unique combination of critical dimension and sidewall angle measurements for each point in a focus energy matrix (FEM - also referred to as Focus Exposure Matrix). If these unique combinations of critical dimension and sidewall angle are available, the focus and dose values may be uniquely determined from these measurements.

A metrology target may be an ensemble of composite gratings, formed by a lithographic process, mostly in resist, but also after etch process for example. The pitch and line-width of the structures in the gratings may strongly depend on the measurement optics (in particular the NA of the optics) to be able to capture diffraction orders coming from the metrology targets. As indicated earlier, the diffracted signal may be used to determine shifts between two layers (also referred to 'overlay') or may be used to reconstruct at least part of the original grating as produced by the lithographic process. This reconstruction may be used to provide guidance of the quality of the lithographic process and may be used to control at least part of the lithographic process. Targets may have smaller sub-segmentation which are configured to mimic dimensions of the functional part of the design layout in a target. Due to this sub-segmentation, the targets will behave more similar to the functional part of the design layout such that the overall process parameter measurements resemble the functional part of the design layout better. The targets may be measured in an underfilled mode or in an overfilled mode. In the underfilled mode, the measurement beam generates a spot that is smaller than the overall target. In the overfilled mode, the measurement beam generates a spot that is larger than the overall target. In such overfilled mode, it may also be possible to measure different targets simultaneously, thus determining different processing parameters at the same time.

Overall measurement quality of a lithographic parameter using a specific target is at least partially determined by the measurement recipe used to measure this lithographic parameter. The term "substrate measurement recipe" may include one or more parameters of the measurement itself, one or more parameters of the one or more patterns measured, or both. For example, if the measurement used in a substrate measurement recipe is a diffraction-based optical measurement, one or more of the parameters of the measurement may include the wavelength of the radiation, the polarization of the radiation, the incident angle of radiation relative to the substrate, the orientation of radiation relative to a pattern on the substrate, etc. One of the criteria to select a measurement recipe may, for example, be a sensitivity of one of the measurement parameters to processing variations. More examples are described in US patent application US2016-0161863 and published US patent application US 2016/0370717A1 incorporated herein by reference in its entirety.

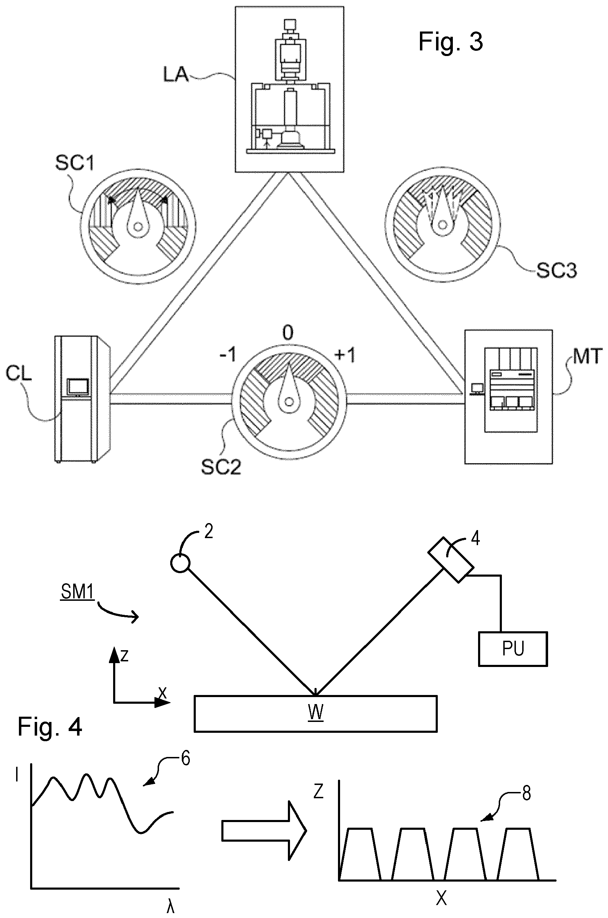

The patterning process in a lithographic apparatus LA may be one of the most critical steps in the processing which requires high accuracy of dimensioning and placement of structures on the substrate W. To ensure this high accuracy, three systems may be combined in a so called "holistic" control environment as schematically depicted in Fig. 3. One of these systems is the lithographic apparatus LA which is (virtually) connected to a metrology tool MT (a second system) and to a computer system CL (a third system). The key of such "holistic" environment is to optimize the cooperation between these three systems to enhance the overall process window and provide tight control loops to ensure that the patterning performed by the lithographic apparatus LA stays within a process window. The process window defines a range of process parameters (e.g. dose, focus, overlay) within which a specific manufacturing process yields a defined result (e.g. a functional semiconductor device) - maybe within which the process parameters in the lithographic process or patterning process are allowed to vary.

The computer system CL may use (part of) the design layout to be patterned to predict which resolution enhancement techniques to use and to perform computational lithography simulations and calculations to determine which mask layout and lithographic apparatus settings achieve the largest overall process window of the patterning process (depicted in Fig. 3 by the double arrow in the first scale SC1). The resolution enhancement techniques may be arranged to match the patterning possibilities of the lithographic apparatus LA. The computer system CL may also be used to detect where within the process window the lithographic apparatus LA is currently operating (e.g. using input from the metrology tool MET) to predict whether defects may be present due to e.g. sub-optimal processing (depicted in Fig. 3 by the arrow pointing "0" in the second scale SC2).

The metrology tool MT may provide input to the computer system CL to enable accurate simulations and predictions, and may provide feedback to the lithographic apparatus LA to identify possible drifts, e.g. in a calibration status of the lithographic apparatus LA (depicted in Fig. 3 by the multiple arrows in the third scale SC3).

In lithographic processes, it is desirable to make frequently measurements of the structures created, e.g., for process control and verification. Various tools for making such measurements are known, including scanning electron microscopes or various forms of metrology apparatuses, such as scatterometers. Examples of known scatterometers often rely on provision of dedicated metrology targets, such as underfilled targets (a target, in the form of a simple grating or overlapping gratings in different layers, that is large enough that a measurement beam generates a spot that is smaller than the grating) or overfilled targets (whereby the illumination spot partially or completely contains the target). Further, the use of metrology tools, for example an angular resolved scatterometter illuminating an underfilled target, such as a grating, allows the use of so-called reconstruction methods where the properties of the grating may be calculated by simulating interaction of scattered radiation with a mathematical model of the target structure and comparing the simulation results with those of a measurement. Parameters of the model are adjusted until the simulated interaction produces a diffraction pattern similar to that observed from the real target.

Scatterometers are versatile instruments which allow measurements of the parameters of a lithographic process by having a sensor in the pupil or a conjugate plane with the pupil of the objective of the scatterometer, measurements usually referred as pupil based measurements, or by having the sensor in the image plane or a plane conjugate with the image plane, in which case the measurements are usually referred as image or field based measurements. Such scatterometers and the associated measurement techniques are further described in patent applications US20100328655, US2011102753A1, US20120044470A, US20110249244, US20110026032 or EP1,628,164A, incorporated herein by reference in their entirety. Aforementioned scatterometers may measure in one image multiple targets from multiple gratings using light from hard X-ray, soft X-ray, extreme ultraviolet and visible to near-IR wave range.

One example of a metrology apparatus, such as a scatterometer, is depicted in Figure 4. It may comprise a broadband (e.g. white light) radiation projector 2 which projects radiation 5 onto a substrate W. The reflected or scattered radiation 10 is passed to a spectrometer detector 4, which measures a spectrum 6 (i.e. a measurement of intensity I as a function of wavelength λ) of the specular reflected radiation. From this data, the structure or profile 8 giving rise to the detected spectrum may be reconstructed by processing unit PU, e.g. by Rigorous Coupled Wave Analysis and non-linear regression or by comparison with a library of simulated spectra as shown at the bottom of Figure 4. In general, for the reconstruction, the general form of the structure is known and some parameters are assumed from knowledge of the process by which the structure was made, leaving only a few parameters of the structure to be determined from the scatterometry data. Such a scatterometer may be configured as a normal-incidence scatterometer or an oblique-incidence scatterometer.

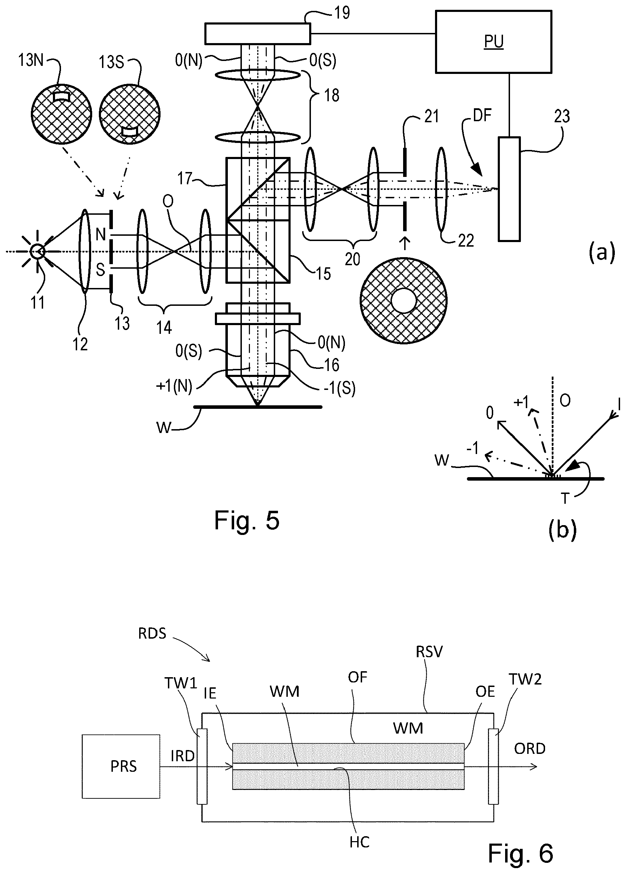

Figure 5(a) presents an embodiment of a metrology apparatus and, more specifically, a dark field scatterometer. A target T and diffracted rays of measurement radiation used to illuminate the target are illustrated in more detail in Figure 5(b). The metrology apparatus illustrated is of a type known as a dark field metrology apparatus. The metrology apparatus may be a stand-alone device or incorporated in either the lithographic apparatus LA, e.g., at the measurement station, or the lithographic cell LC. An optical axis, which has several branches throughout the apparatus, is represented by a dotted line O. In this apparatus, light emitted by source 11 (e.g., a xenon lamp) is directed onto substrate W via a beam splitter 15 by an optical system comprising lenses 12, 14 and objective lens 16. These lenses are arranged in a double sequence of a 4F arrangement. A different lens arrangement can be used, provided that it still provides a substrate image onto a detector, and simultaneously allows for access of an intermediate pupil-plane for spatial-frequency filtering. Therefore, the angular range at which the radiation is incident on the substrate can be selected by defining a spatial intensity distribution in a plane that presents the spatial spectrum of the substrate plane, here referred to as a (conjugate) pupil plane. In particular, this can be done by inserting an aperture plate 13 of suitable form between lenses 12 and 14, in a plane which is a back-projected image of the objective lens pupil plane. In the example illustrated, aperture plate 13 has different forms, labeled 13N and 13S, allowing different illumination modes to be selected. The illumination system in the present examples forms an off-axis illumination mode. In the first illumination mode, aperture plate 13N provides off-axis from a direction designated, for the sake of description only, as 'north'. In a second illumination mode, aperture plate 13S is used to provide similar illumination, but from an opposite direction, labeled 'south'. Other modes of illumination are possible by using different apertures. The rest of the pupil plane is desirably dark as any unnecessary light outside the desired illumination mode will interfere with the desired measurement signals.

As shown in Figure 5(b), target T is placed with substrate W normal to the optical axis O of objective lens 16. The substrate W may be supported by a support (not shown). A ray of measurement radiation I impinging on target T from an angle off the axis O gives rise to a zeroth order ray (solid line 0) and two first order rays (dot-chain line +1 and double dot-chain line -1). It should be remembered that with an overfilled small target, these rays are just one of many parallel rays covering the area of the substrate including metrology target T and other features. Since the aperture in plate 13 has a finite width (necessary to admit a useful quantity of light, the incident rays I will in fact occupy a range of angles, and the diffracted rays 0 and +1/-1 will be spread out somewhat. According to the point spread function of a small target, each order +1 and -1 will be further spread over a range of angles, not a single ideal ray as shown. Note that the grating pitches of the targets and the illumination angles can be designed or adjusted so that the first order rays entering the objective lens are closely aligned with the central optical axis. The rays illustrated in Figure 5(a) and 5(b) are shown somewhat off axis, purely to enable them to be more easily distinguished in the diagram.

At least the 0 and +1 orders diffracted by the target T on substrate W are collected by objective lens 16 and directed back through beam splitter 15. Returning to Figure 5(a), both the first and second illumination modes are illustrated, by designating diametrically opposite apertures labeled as north (N) and south (S). When the incident ray I of measurement radiation is from the north side of the optical axis, that is when the first illumination mode is applied using aperture plate 13N, the +1 diffracted rays, which are labeled +1(N), enter the objective lens 16. In contrast, when the second illumination mode is applied using aperture plate 13S the -1 diffracted rays (labeled 1(S)) are the ones which enter the lens 16.

A second beam splitter 17 divides the diffracted beams into two measurement branches. In a first measurement branch, optical system 18 forms a diffraction spectrum (pupil plane image) of the target on first sensor 19 (e.g. a CCD or CMOS sensor) using the zeroth and first order diffractive beams. Each diffraction order hits a different point on the sensor, so that image processing can compare and contrast orders. The pupil plane image captured by sensor 19 can be used for focusing the metrology apparatus and/or normalizing intensity measurements of the first order beam. The pupil plane image can also be used for many measurement purposes such as reconstruction.

In the second measurement branch, optical system 20, 22 forms an image of the target T on sensor 23 (e.g. a CCD or CMOS sensor). In the second measurement branch, an aperture stop 21 is provided in a plane that is conjugate to the pupil-plane. Aperture stop 21 functions to block the zeroth order diffracted beam so that the image of the target formed on sensor 23 is formed only from the -1 or +1 first order beam. The images captured by sensors 19 and 23 are output to processor PU which processes the image, the function of which will depend on the particular type of measurements being performed. Note that the term 'image' is used here in a broad sense. An image of the grating lines as such will not be formed, if only one of the -1 and +1 orders is present.

The particular forms of aperture plate 13 and field stop 21 shown in Figure 5 are purely examples. In another embodiment of the invention, on-axis illumination of the targets is used and an aperture stop with an off-axis aperture is used to pass substantially only one first order of diffracted light to the sensor. In yet other embodiments, 2nd, 3rd and higher order beams (not shown in Figure 5) can be used in measurements, instead of or in addition to the first order beams.

In order to make the measurement radiation adaptable to these different types of measurement, the aperture plate 13 may comprise a number of aperture patterns formed around a disc, which rotates to bring a desired pattern into place. Note that aperture plate 13N or 13S can only be used to measure gratings oriented in one direction (X or Y depending on the set-up). For measurement of an orthogonal grating, rotation of the target through 90° and 270° might be implemented. Different aperture plates may be used, for example to enable simultaneous illumination in two opposing directions, in both X and Y. The use of these, and numerous other variations and applications of the apparatus are described in prior published applications, mentioned above.

Figure 6 depicts a radiation source RDS which may be used for providing broadband output radiation for use as measurement radiation in the concepts disclosed herein, and for the metrology tool of Figure 5(a). The radiation source RDS comprises a pulsed pump radiation source PRS or any other type of source that is capable of generating short pulses of a desired length and energy level; an optical fiber OF with a hollow core HC; and a working medium WM (for example a gas) disposed within the hollow core HC. he pulsed pump radiation source PRS is configured to provide input radiation IRD. The hollow core HC of the optical fiber OF is arranged to receive the input radiation IRD from the pulsed pump radiation source PRS, and broaden it to provide output radiation ORD. The working medium WM enables the broadening of the frequency range of the received input radiation IRD so as to provide broadband output radiation ORD.

The radiation source RDS further comprises a reservoir RSV. The optical fiber OF is disposed inside the reservoir RSV. The reservoir RSV may also be referred to as a housing, container or gas cell. The reservoir RSV is configured to contain the working medium WM. The reservoir RSV may comprise one or more features, known in the art, for controlling, regulating, and/or monitoring the composition of the working medium WM (which may be a gas) inside the reservoir RSV. The reservoir RSV may comprise a first transparent window TW1. In use, the optical fiber OF is disposed inside the reservoir RSV such that the first transparent window TW1 is located proximate to an input end IE of the optical fiber OF. The first transparent window TW1 may form part of a wall of the reservoir RSV. The first transparent window TW1 may be transparent for at least the received input radiation frequencies, so that received input radiation IRD (or at least a large portion thereof) may be coupled into the optical fiber OF located inside reservoir RSV. It will be appreciated that optics (not shown) may be provided for coupling the input radiation IRD into the optical fiber OF. The reservoir RSV comprises a second transparent window TW2, forming part of a wall of the reservoir RSV. In use, when the optical fiber OF is disposed inside the reservoir RSV, the second transparent window TW2 is located proximate to an output end OE of the optical fiber OF. The second transparent window TW2 may be transparent for at least the frequencies of the broadband output radiation ORD of the apparatus 120.

Alternatively, in another embodiment, the two opposed ends of the optical fiber OF may be placed inside different reservoirs. The optical fiber OF may comprise a first end section configured to receive input radiation IRD, and a second end section for outputting broadband output radiation ORD. The first end section may be placed inside a first reservoir, comprising a working medium WM. The second end section may be placed inside a second reservoir, wherein the second reservoir may also comprise a working medium WM. The functioning of the reservoirs may be as described in relation to Figure 6 above. The first reservoir may comprise a first transparent window, configured to be transparent for input radiation IRD. The second reservoir may comprise a second transparent window configured to be transparent for broadband output broadband radiation ORD. The first and second reservoirs may also comprise a sealable opening to permit the optical fiber OF to be placed partially inside and partially outside the reservoir, so that a gas can be sealed inside the reservoir. The optical fiber OF may further comprise a middle section not contained inside a reservoir. Such an arrangement using two separate gas reservoirs may be particularly convenient for embodiments wherein the optical fiber OF is relatively long (for example when the length is more than 1 m). It will be appreciated that for such arrangements which use two separate gas reservoirs, the two reservoirs (which may comprise one or more features, known in the art, for controlling, regulating, and/or monitoring the composition of a gas inside the two reservoirs) may be considered to provide an apparatus for providing the working medium WM within the hollow core HC of the optical fiber OF.

Both the first TW1 and the second TW2 transparent windows may form an airtight seal within the walls of the reservoir RSV so that the working medium WM (which may be a gas) may be contained within the reservoir RSV. It will be appreciated that the gas WM may be contained within the reservoir RSV at a pressure different to the ambient pressure of the reservoir RSV.

The working medium WM may comprise a noble gas such as Argon, Krypton, and Xenon, a Raman active gas such as Hydrogen, Deuterium and Nitrogen, or a gas mixture such as an Argon/Hydrogen mixture, a Xenon/Deuterium mixture, a Krypton/Nitrogen mixture, or a Nitrogen/Hydrogen mixture. Depending on the type of filling gas, the nonlinear optical processes can include modulational instability (MI), soliton self-compression, soliton fission, Kerr effect, Raman effect and dispersive wave generation (DWG), details of which are described in WO2018/127266A1 and US9160137B1 (both of which are hereby incorporated by reference). Since the dispersion of the filling gas can be tuned by varying the working medium WM pressure in the reservoir RSR (i.e. gas cell pressure), the generated broadband pulse dynamics and the associated spectral broadening characteristics can be adjusted so as to optimize the frequency conversion

In order to achieve frequency broadening high intensity radiation may be desirable. An advantage of having a hollow core HC optical fiber OF is that it may achieve high intensity radiation through strong spatial confinement of radiation propagating through the optical fiber OF, achieving high localised radiation intensities. The radiation intensity inside the optical fiber OF may be high, for example due to high received input radiation intensity and/or due to strong spatial confinement of the radiation inside the optical fiber OF. An advantage of hollow core optical fibers is that they can guide radiation having a broader wavelength range than solid-core fibers and, in particular, hollow core optical fibers can guide radiation in both the ultraviolet and infrared ranges.

An advantage of using a hollow core HC optical fiber OF may be that the majority of the radiation guided inside the optical fiber OF is confined to the hollow core HC. Therefore, the majority of the interaction of the radiation inside the optical fiber OF is with the working medium WM, which is provided inside the hollow core HC of the optical fiber OF. As a result, the broadening effects of the working medium WM on the radiation may be increased.

The received input radiation IRD may be electromagnetic radiation. The input radiation IRD may be received as pulsed radiation. For example, the input radiation IRD may comprise ultrafast pulses, for example, generated by a laser. The input radiation IRD may be coherent radiation. The input radiation IRD may be collimated radiation, an advantage of which may be to facilitate and improve the efficiency of coupling the input radiation IRD into the optical fiber OF. The input radiation IRD may comprise a single frequency, or a narrow range of frequencies. The input radiation IRD may be generated by a laser. Similarly, the output radiation ORD may be collimated and/or may be coherent.

The broadband range of the output radiation ORD may be a continuous range, comprising a continuous range of radiation frequencies. The output radiation ORD may comprise supercontinuum radiation. Continuous radiation may be beneficial for use in a number of applications, for example in metrology applications. For example, the continuous range of frequencies may be used to interrogate a large number of properties. The continuous range of frequencies may for example be used to determine and/or eliminate a frequency dependency of a measured property. Supercontinuum output radiation ORD may comprise for example electromagnetic radiation over a wavelength range of 100 nm - 4000 nm. The broadband output radiation ORD frequency range may be for example 400 nm - 900 nm, 500 nm - 900 nm, or 200 nm - 2000 nm. The supercontinuum output radiation ORD may comprise white light.

The input radiation IRD provided by the pulsed pump radiation source PRS may be pulsed. The input radiation IRD may comprise electromagnetic radiation of one or more frequencies between 200 nm and 2 µm. The input radiation IRD may for example comprise electromagnetic radiation with a wavelength of 1.03 µm. The repetition rate of the pulsed radiation IRD may be of an order of magnitude of 1 kHz to 100 MHz. The pulse energies may have an order of magnitude of 0.1 µJ to 100 µJ, for example 1-10 µJ. A pulse duration for the input radiation IRD may be between 10 fs and 10 ps, for example 300 fs. The average power of input radiation IRD may be between 100 mW to several 100 W. The average power of input radiation IRD may for example be 20 - 50 W.

The pulsed pump radiation source PRS may be a laser. The spatio-temporal transmission characteristics of such a laser pulse, e.g. its spectral amplitude and phase, transmitted along the optical fiber OF can be varied and tuned through adjustment of (pump) laser parameters, working component WM variations, and optical fiber OF parameters. Said spatio-temporal transmission characteristics may include one or more of: output power, output mode profile, output temporal profile, width of the output temporal profile (or output pulse width), output spectral profile, and bandwidth of the output spectral profile (or output spectral bandwidth). Said pulsed pump radiation source PRS parameters may include one or more of: pump wavelength, pump pulse energy, pump pulse width, pump pulse repetition rate. Said optical fiber OF parameters may include one or more of: optical fiber length, size and shape of the hollow core HC, size and shape of the capillaries, thickness of the walls of the capillaries surrounding the hollow core HC. Said working component WM, e.g. filling gas, parameters may include one or more of: gas type, gas pressure and gas temperature.

The broadband output radiation ORD provided by the radiation source RDS may have an average output power of at least 1 W. The average output power may be at least 5 W. The average output power may be at least 10 W. The broadband output radiation ORD may be pulsed broadband output radiation ORD. The broadband output radiation ORD may have a power spectral density in the entire wavelength band of the output radiation of at least 0.01 mW/nm. The power spectral density in the entire wavelength band of the broadband output radiation may be at least 3 mW/nm.

In a metrology tool MT, source radiation may be emitted from a radiation source and directed onto a target structure (or other structure) formed via a lithographic process on a substrate. The target structure may reflect and/or diffract the source radiation incident on the target structure. The metrology tool MT may comprise one or more sensors for detecting diffracted radiation. For example, a metrology tool MT may comprise detectors for detecting the positive (+1st) and negative (-1st) first diffraction orders. The metrology tool MT may also measure or block the specular reflected radiation (0th order diffracted radiation). Further sensors for metrology may be present in the metrology tool MT, for example to measure further diffraction orders (e.g. higher diffraction orders).

An issue with such measurements is that scattering of the measurement radiation by various surfaces within the metrology tool and/or by the substrate surface/stack being measured results in stray light, imaging artefacts or ghosts in the measured image. These ghosts result in a reduction in the signal-to-noise ratio of the measured image. Internal ghosts are caused by light being scattered by components within the optical system. External ghosts are caused by light being scattered by objects outside the optical system, e.g., the measured wafer. Internal ghosts may be corrected by recording images when the system is pointed at a beam dump and subtracting these ghost images from all the measurement images. This can be effective if not perfect. For external ghosts, images may be recorded when the system is pointed at a reflector (e.g., a reflecting reference substrate) and again subtracted from the measurement images. However, such external ghost corrections suffer from not being measured on the same stack as that on which the metrology targets are placed. This means that the real external ghost experienced during measurement will always be different than the one measured during external ghost calibration.

As such, an improved method of mitigating or removing such ghosts is sought. Disclosed herein are methods and apparatuses which directly generate high harmonic second radiation from the measured diffractive structure; e.g., a metrology target on a wafer. This can be achieved by illuminating the sample with first radiation e.g., comprising sufficiently short radiation pulses (e.g., on the femtosecond order of magnitude or smaller than 0.1ps), and measuring the diffracted high harmonic emission resulting from excitation of the sample by the radiation pulses.

The high harmonic radiation may comprise any one or more harmonics above the fundamental, and in an embodiment may comprise second harmonic radiation having half the wavelength of the first radiation used to illuminate the sample. In an overlay context, this high harmonic radiation will be diffracted by both gratings of an overlay target in the same manner as the first radiation; e.g., into at least one pair of complementary higher diffraction orders, where a pair of complementary higher diffraction orders comprises the positive and negative diffraction of the same order number (e.g., +1 order and -1 order). As such, a parameter of interest (e.g., any parameter of interest which can be inferred from an imbalance in the intensity/amplitude and/or phase between each of a pair of complementary diffraction orders, such as overlay or focus) may be determined from these second harmonic diffraction orders in the same manner as presently done using the fundamental diffraction orders.

As such, disclosed herein is a metrology apparatus for measurement of a diffractive structure on a substrate, comprising: a radiation source operable to provide first radiation having a first wavelength (or fundamental wavelength) for excitation of the diffractive structure; a detection arrangement operable to detect at least diffracted second radiation, said diffracted second radiation comprising a second harmonic (and/or higher harmonic) of said first radiation, said diffracted second radiation having a second wavelength and being generated from said diffractive structure and/or substrate and diffracted by said diffractive structure; and a processing arrangement operable to determine a parameter of interest from at least said diffracted second radiation.

By determining the parameter of interest from the second harmonic diffraction orders, noise due to ghosting can be highly suppressed, as there will be no reflection of the expose beam at the second harmonic detection wavelength. As such, for example, the fundamental wavelength may be blocked or diverted elsewhere in the detection path, thereby also blocking noise due to ghosting which will also be at this fundamental wavelength.

The fundamental diffraction orders at the first radiation wavelength can optionally also be separately detected and used to derive the parameter of interest, e.g., to make the measurement more robust. This also ensures backwards compatibility with present metrology tools and methods. Furthermore, the fundamental may also be used to find optimal focus and/or pulse shaper setting for the second harmonic signal. The intensity of the second harmonic has a non-linear dependency on these settings, which is not the case for the fundamental. Hence the fundamental may be preferred when performing the initial setting up of the focus and/or pulse shaper setting, and once the second harmonic is detected, this second harmonic signal can be used for further refining of the focus and/or pulse shaper setting.

Normal light scattering or diffraction is proportional to the linear polarizability χ (i.e. χ¹ ) of the target material. Every material that lacks inversion symmetry also has a non-linear polarizability χ². At sufficiently high intensity, coherent light is emitted at half the wavelength of the expose beam to the sample. The required light intensity depends on the (frequency-dependent) magnitude of χ². It is known to use second harmonic generation to study the surface structure of metals and biological materials.

Since resist has no inversion symmetry it has a non-linear polarizability χ², thereby enabling the detection of grating asymmetry changes through focus or overlay via an intensity difference between +1 and -1 diffraction orders of second harmonic diffraction orders.

When using a supercontinuum light source, such as illustrated in Figure 6, it is relatively straightforward to select sufficient and coherent bandwidth from the output spectrum so as to create pulses with a duration of less than 100 fs, which still have a sufficiently high pulse energy to generate the second harmonic radiation. By controlling the dispersion of the light, these bright ultrashort laser pulses can be delivered to a structure (e.g., target) on a wafer, where they create a coherent diffracted beam at the second harmonic of the expose beam. How much second harmonic energy is emitted either into the wafer or emitted equally in the forward and backward direction is dependent on the ratio of the pitch of the target to the fundamental wavelength. Due to the short pulse duration, the wafer/resist should not be damaged despite the high intensity, as an ultrashort pulse does not carry much power.

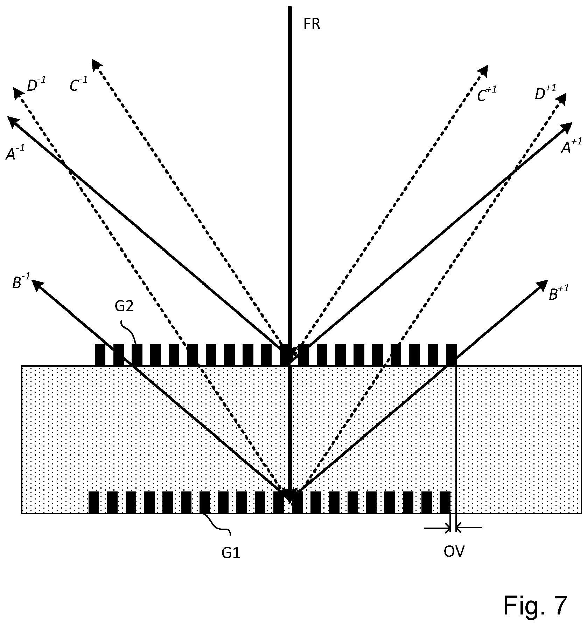

When the focus range of the expose beam is similar (or larger than) the stack thickness, each consecutive patterned layer in an overlay target will generate a diffracted second harmonic beam in a similar way. Figure 7 is a simplified schematic of the expected diffraction orders for second harmonic overlay target for an example where the parameter of interest is overlay OV. The overlay target comprises a first grating G1 in a first layer and a second grating G2 on a second layer, and is excited by first radiation FR. The diffracted second radiation comprises second harmonic diffraction orders in the return direction *C₋₁, D*₋*₁, C₊₁, D₊₁* (dashed lines) which carry overlay information. The overlay information can be retrieved from these second harmonic diffraction orders in a similar way as from the diffracted or scattered first radiation comprising fundamental diffraction orders *A₋₁*, *B*₋*₁, A*_{+*1*}, *B₊₁* (solid lines), i.e., using the techniques presently used in diffraction based overlay methods.

It can be appreciated that second harmonic diffraction orders from the top grating will also be generated in the forward direction (not shown). It is possible that these will diffract again at the bottom grating and create additional signals which can optionally be used in the overlay retrieval, either by coherent interference with a reflected beam or another diffracted beam at either the fundamental wavelength or second harmonic wavelength. For example, this could be modeled by simulating the intense light beam propagation in a simplified stack, e.g., using finite-difference time-domain FTDT simulations with realistic values for the χ¹ and χ² for the relevant materials.

Second harmonic generation occurs most efficiently at the surface of a material, where the difference in the refractive indices is largest. This is beneficial for overlay or focus metrology when using thinner (e.g., EUV) resists. For example, certain focus target designs, which have an asymmetry dependent on the focus setting during exposure, have a low diffraction efficiency (DE). This increases the inaccuracy impact of incorrect ghost calibrations when using conventional ghost calibration techniques. In practice, this translates into a large machine matching error in focus measurements using such targets. The physical reason for this low DE is a combination of such focus targets being single layer targets and the small resist thickness used e.g., when used for monitoring of EUV exposures. Thinner resists yield strongly reduced diffraction efficiency at the fundamental wavelength, as the latter is proportional to the resist volume. Because, second harmonic generation is more proportional to surface area and the amount of surface area remains the same with thinner resists as with thicker resists used for longer wavelength exposures, there is no correspondingly large decrease in second harmonic diffraction efficiency as resist thickness decreases.

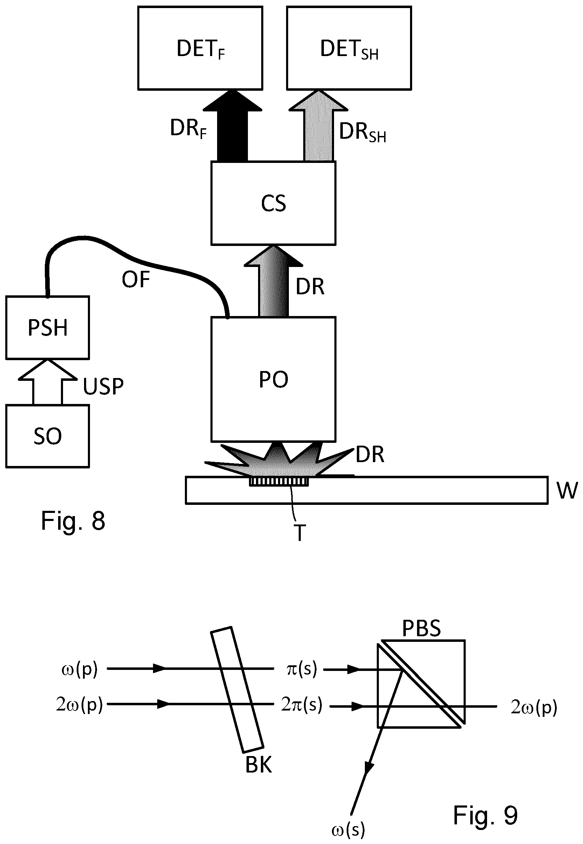

Figure 8 is a schematic diagram of a metrology device implementing the concepts disclosed herein. An illumination source SO, which may be an ultrashort light pulse source, for example such as illustrated in Figure 6, generates ultrashort pulse radiation USP. A pulse shaping device PS may be used to control the chromatic dispersion thereby defining the pulse duration and intensity. An example of a suitable pulse shaper is published in Knippels, G.M.H., et al., Optics Communications, 118 (1995) 546-550, which is hereby incorporated by reference.

An optical fiber OF may be used to deliver the shaped ultrashort light pulses to projection optics PO in an optical column. The projection optics PO projects the pulsed fundamental beam onto a target T on wafer W, and collects the diffracted radiation DR (e.g., the +1 and -1 orders) of at least the generated second harmonic scattered radiation DR. As shown here, the projection optics may also collect the diffracted radiation DR (e.g., the +1 and -1 orders) at the fundamental wavelength.

In the embodiment shown, a wavelength separator or color separator CS is used to separate the fundamental diffracted radiation DR_{F} and second harmonic diffracted radiation DR_{SH}. Both fundamental diffracted radiation DR_{F} and second harmonic diffracted radiation DR_{SH} may be detected by a detection arrangement comprising separate detectors DET_{F}, DET_{SH} (as shown here) or a single detector (e.g., such that the fundamental diffracted radiation DR_{F} and second harmonic diffracted radiation DR_{SH} are detected on different parts of the same detector). Alternatively, the fundamental diffracted radiation DR_{F} may be discarded. A color separator is one example of a wavelength separation or filtering arrangement which may be used. In other embodiments, instead of a color separator, a suitable band-pass filter or low-pass filter may be used to block the fundamental diffracted radiation DR_{F} and pass only the second harmonic diffracted radiation DR_{SH}. In other embodiments, only the second harmonic diffracted radiation DR_{SH} is collected by collection optics (e.g., the projection system) as it will diffract at different angles to the fundamental diffracted radiation.

By detecting the second harmonic diffracted radiation separately of the fundamental diffracted radiation (whether the latter is blocked or separately detected) means that the fundamental background noise will be removed, *inter alia* by filtering out ghost images at the fundamental wavelength. This improves the achievable measurement speed by improving the signal-to-noise ratio of the second harmonic signal.

Figure 9 illustrates an (optics based) embodiment of the color separator CS usable in the metrology tool of Figure 8. In this embodiment, color separator CS comprises a combination of a Berek retardation compensator BK and a polarizing beam splitter PBS (e.g. Glan-Taylor polarizer). Such a color separator CS enables detection of the fundamental and second harmonic wavelengths simultaneously. Per color channel, an image of the target may be detected at a plane that is optically conjugated to the wafer.

Such a color separator conserves the high imaging quality of the diffracted beams, is easily and widely tunable as the components can be made from Calcite, and separates the beams spatially while providing the option to detect the image simultaneously in each color channel. Such a color separator is expected to suppress very well any ghost images in the second harmonic channel.

To use such a color separator, it is assumed that the output of the radiation source at the output of the fiber is either purely s-polarized or p-polarized. In this embodiment, it is an important attribute of the combined diffracted beams that they all have the same polarization, as the second harmonic beam is generated using a non-phase matching interaction with the first grating and second grating. This enables utilization of a specific attribute of the Berek polarizer: at every setting of the dial, the optical retardation of the second harmonic 2*ω* is twice as large as the retardation at the fundamental wavelength *ω*. Therefore, by setting the retardation at π for the fundamental wavelength *ω* and (hence) at 2*π* for the second harmonic 2*ω*, the incoming diffracted beams can be separated using a broadband polarizing beam splitter.

This is only one embodiment of a color separator, other methods and devices may be used to separate the second harmonic diffracted radiation from the fundamental diffracted radiation. However, it is desirable that the fundamental wavelength can be tuned over an extremely wide range, e.g., between 1.8µm-300nm. The corresponding range of the second harmonic would be 900nm-150 nm.

It should be appreciated that the color separator disclosed above has applications outside of those described and disclosed herein, and outside of metrology applications generally. In other words, the disclosed color separator can be used independently of the metrology apparatus for measurement of a diffractive structure. As such, disclosed herein is a color separator comprising a combination of a Berek retardation compensator and a polarizing beam splitter (e.g. Glan-Taylor polarizer).

In an embodiment, it may be possible to also detect interference between the +1/-1 order of the fundamental diffracted radiation and the +2/-2 order of the second harmonic diffracted radiation, as both beams and all diffracted orders are coherent with each other, thereby generating further signals conveying the parameter of interest.

It will be understood that, in addition to the second harmonic or as an alternative, diffraction of the third and/or higher order harmonic wavelengths may be used to derive a parameter of interest in a similar manner as with the second harmonic.

In much of the above description, the parameter of interest is overlay. However, the concepts are equally applicable to focus metrology for inferring the focus setting used to expose a focus target, the focus target being formed with a focus dependent asymmetry.

The concepts disclosed herein are also applicable to measurement of Focus biased CD targets which can be used to measure a focus parameter (and optionally a dose parameter). Such a target may comprise at least two sub-targets: at least one non-isofocal sub-target and at least one isofocal sub-target. Each sub-target may be a simple line-space grating. The target may be suitable for on-product application. The focus parameter and dose parameter for a structure may describe the focus setting and dose setting respectively of the lithographic exposure apparatus (scanner) when exposing the structure.

A method for determining a focus parameter from such a target on a substrate, the target comprising a first sub-target and second sub-target, may comprise: obtaining a first measurement signal from second harmonic radiation relating to measurement of the first sub-target, said first sub-target comprising an isofocal structure; obtaining a second measurement signal from second harmonic radiation .relating to measurement of the second sub-target, said second sub-target comprising an non-isofocal structure; obtaining at least one trained relationship and/or model which relates at least said second measurement signal to said focus parameter; and determining a value for said focus parameter from said first measurement signal, second measurement signal and said at least one trained relationship and/or model.

An isofocal sub-target in the context of this disclosure is a sub-target which is formed with less than 5%, 3%, 2% or 1% variation in CD over a focus range of at least 60nm.

There may be a substantial best focus shift between the at least one non-isofocal sub-target and the isofocal sub-target. Best focus may indicate a focus setting for which CD variation is minimal over a small range (e.g., +/- 5nm) around the best focus and/or a focus setting at the peak or trough of a corresponding Bossung curve for that sub-target; i.e., where CD sensitivity for small focus changes is lowest. In an embodiment, the non-isofocal sub-target should print (be exposed) at the best focus of the isofocal sub-target. Optionally the isofocal sub-target should print (be exposed) at the best focus of the non-isofocal sub-target.

The best focus of the isofocal sub-target may be the same as or close to (e.g., within 20nm, within 10nm or within 5nm of) the best focus of the product structure. In an embodiment, the best focus difference between best focus of the (or each) non-isofocal target and the isofocal target (or product structure) may be greater than 40nm, greater than 50nm, be greater than 60nm, be greater than 70nm or be greater than 80nm. Best focus for a feature may be determined in a computational lithography step such as source mask optimization (SMO). The objective of SMO is to maximize the number of patterns (and in particular critical patterns for which the process window is small) that have sufficient imaging performance such as focus margin or dose latitude for a particular illumination condition (and optimized in combination with the illumination condition). As such, the source and mask (reticle) may be optimized such that product patterns are exposed with minimal CD dependence on focus (and dose). However, this is not desirable for a focus target.

The best focus of each of the sub-targets may have their respective best focus tuned by varying the pitch and/or mask CD (i.e., CD of the reticle feature which forms the grating line of the sub-target); the best focus of an individual feature can be varied/tuned by modifying one or both of its pitch or mask CD. Alternatively, or in addition, the best focus shift between each of the sub-targets computational lithography/SMO may be performed to determine a best focus for the product. The isofocal sub-target may then be tuned (via CD and/or pitch) to have a first best focus value which is substantially similar to that of the product structure (this may be done during SMO or subsequently). The non-isofocal sub-target may then be tuned (via CD and/or pitch) to have a best focus value which is substantially different to that of the isofocal sub-target. This tuning may be done in a target optimization phase, and may be (for example) performed virtually (e.g., via computational lithography) or otherwise (e.g., by reference to known variation of best focus with pitch and/or CD, or by trial and error). As such, the non-isofocal sub-target and the isofocal sub-target may differ from each other in terms of pitch and/or CD. In particular the tuning of the non-isofocal sub-target may be such that the focus sensitivity around the product structures' best focus is maximized or is at least above a threshold sensitivity value (e.g., on the Bossung slope, away from the peak). Of course, it is important that the non-isofocal sub-target prints at this product structure (and isofocal sub-target) best focus value.

By tuning the best focus value of the non-isofocal sub-target sufficiently away from the peak, the variation of CD with focus of the non-isofocal sub-target can be made monotonic within a range of interest, i.e., around the first best focus value and extending over a range covering any expected focus variation during exposure. Optionally a second non-isofocal sub-target may be included with different focus sensitivity (e.g., tuned to have a different best focus by having a different CD and/or pitch). The CD difference of these targets should vary monotonically with focus over an even greater range may result from mask 3D effects and may be obtained, for example, by using different mask absorber types including the standard Ta-based absorber, low-n absorbers with refractive index n<0.92 (and other EUV absorbers).

A second harmonic pair of complementary diffraction orders from such focus targets can be used to derive focus and dose.

In addition to the aforementioned signal-to-noise benefits, there may be other advantages of the concepts disclosed herein. For example, when using shorter wavelengths (blue to UV) with current metrology techniques, there is a (small) risk of activating the resist. The "blue" dose in the second harmonic generation will be two orders lower, as the first radiation may comprise "red" illumination and it may be that only 1% of the power is up-converted into the "blue" channel. Also, the shorter wavelength of the second harmonic may yield a detectable second harmonic diffraction signal from a target having half the lower limit for the target pitch which would otherwise be possible when detecting the fundamental. This enables the target pitch to be closer to the critical dimension of the product structure.

The application range of metrology applications/tools may be limited to the shortest wavelength of the illumination source. However, by using the second harmonic (or higher harmonics) this wavelength range is extended by up to a factor two (or more) shorter wavelengths.

Further embodiments are disclosed in the subsequent list of numbered clauses:
1. A metrology apparatus for measurement of a diffractive structure on a substrate, comprising:
   a radiation source operable to provide first radiation for excitation of the diffractive structure, said first radiation having a first wavelength;
   a detection arrangement operable to detect at least diffracted second radiation comprising a second harmonic of said first radiation, said diffracted second radiation being generated from said diffractive structure and/or substrate and diffracted by said diffractive structure; and
   a processing arrangement operable to determine a parameter of interest relating to said diffractive structure from at least said diffracted second radiation.
2. A metrology apparatus as defined in clause 1, comprising a wavelength separation or filtering arrangement operable to separate or filter out scattered first radiation from said diffracted second radiation, prior to said detection arrangement, said scattered first radiation having been scattered and/or diffracted from said diffractive structure and having said first wavelength.
3. A metrology apparatus as defined in clause 2, wherein the wavelength separation or filtering arrangement comprises a Berek polarizer and polarizing beam splitter.
4. A metrology apparatus as defined in clause 3, wherein the radiation source is operable to provide said first radiation as s-polarized or p-polarized first radiation and said Berek polarizer has a retardation set at *π* for the first wavelength.
5. A metrology apparatus as defined in clause 3 or 4, wherein the polarizing beam splitter comprises a Glan-Taylor polarizer.
6. A metrology apparatus as defined in any of clauses 2 to 5, wherein said detection arrangement is operable to detect said scattered first radiation.
7. A metrology apparatus as defined in clause 6, wherein said processing arrangement is operable to determine a pulse shape setting for said first radiation and/or a focus setting from said scattered first radiation.
8. A metrology apparatus as defined in clause 6 or 7, wherein said detection arrangement is operable to detect interference between a first order of the first scattered radiation and a second order of the second diffracted radiation; and said processing arrangement is operable to determine said parameter of interest from said interference.
9. A metrology apparatus as defined in any of clauses 2 to 5, wherein the wavelength separation or filtering arrangement comprises a band-pass or low-pass filter.
10. A metrology apparatus as defined in any of clauses 2 to 5, wherein the wavelength separation or filtering arrangement comprises is effected by said collection optics of said metrology device not collecting said scattered first radiation.
11. A metrology apparatus as defined in any preceding clause, wherein the radiation source is a pulsed radiation source operable to provide said first radiation as a train of pulses, each pulse being shorter than 0.1ps.
12. A metrology apparatus as defined in clause 11, wherein the radiation source is a broadband or supercontinuum radiation source.
13. A metrology apparatus as defined in clause 11 or 12, comprising a pulse shaping device between the radiation source and substrate and being operable to control the chromatic dispersion of the first radiation thereby defining the pulse duration and/or intensity.
14. A metrology apparatus as defined in clause 11, 12 or 13, wherein said radiation source and/or said pulse shaping device provides for tuning of said first wavelength between 1.8µm-300nm.
15. A metrology apparatus as defined in any preceding clause, wherein said diffracted second radiation comprises at least a pair of complementary diffraction orders, and said processing arrangement is operable to determine said parameter of interest from a difference or imbalance of a parameter between the respective diffraction orders of the pair of complementary diffraction orders.
16. A metrology apparatus as defined in any preceding clause, wherein the parameter of interest is overlay or focus.
17. A metrology apparatus for measurement of a diffractive structure on a substrate, comprising:
   a radiation source operable to provide first radiation for excitation of the diffractive structure, said first radiation having a first wavelength;
   a wavelength separation or filtering arrangement operable to separate or filter out scattered first radiation from diffracted second radiation comprising a higher harmonic of said first radiation, wherein said diffracted second radiation is generated from said diffractive structure and/or substrate and diffracted by said diffractive structure and said scattered first radiation has been scattered and/or diffracted from said diffractive structure and comprises said first wavelength;
   a detection arrangement operable to detect at least said diffracted second radiation; and
   a processing arrangement operable to determine a parameter of interest relating to said diffractive structure from at least said diffracted second radiation.
18. A metrology apparatus as defined in clause 17, wherein the wavelength separation or filtering arrangement comprises a Berek polarizer and polarizing beam splitter.
19. A metrology apparatus as defined in clause 18, wherein the radiation source is operable to provide said first radiation as s-polarized or p-polarized first radiation and said Berek polarizer has a retardation set at *π* for the first wavelength.
20. A metrology apparatus as defined in clause 18 or 19, wherein the polarizing beam splitter comprises a Glan-Taylor polarizer.
21. A metrology apparatus as defined in any of clauses 17 to 20, wherein said detection arrangement is operable to detect said scattered first radiation.
22. A metrology apparatus as defined in clause 21, wherein said processing arrangement is operable to determine a pulse shape setting for said first radiation and/or a focus setting from said scattered first radiation.
23. A metrology apparatus as defined in clause 21 or 22, wherein said detection arrangement is operable to detect interference between a first order of the first scattered radiation and a second order of the second diffracted radiation; and said processing arrangement is operable to determine said parameter of interest from said interference.
24. A metrology apparatus as defined in any of clauses 17 to 21, wherein the wavelength separation or filtering arrangement comprises a band-pass or low-pass filter.
25. A metrology apparatus as defined in any of clauses 17 to 21, wherein the wavelength separation or filtering arrangement comprises is effected by said collection optics of said metrology device not collecting said scattered first radiation.
26. A metrology apparatus as defined in any of clauses 17 to 25, wherein the radiation source is a pulsed radiation source operable to provide said first radiation as a train of pulses, each pulse being shorter than 0.1ps.
27. A metrology apparatus as defined in clause 26, wherein the radiation source is a broadband or supercontinuum radiation source.
28. A metrology apparatus as defined in clause 26 or 27, comprising a pulse shaping device between the radiation source and substrate and being operable to control the chromatic dispersion of the first radiation thereby defining the pulse duration and/or intensity.
29. A metrology apparatus as defined in clause 26, 27 or 28, wherein said radiation source and/or said pulse shaping device provides for tuning of said first wavelength between 1.8µm-300nm.
30. A metrology apparatus as defined in any of clauses 17 to 29, wherein said diffracted second radiation comprises at least a pair of complementary diffraction orders, and said processing arrangement is operable to determine said parameter of interest from a difference or imbalance of a parameter between the respective diffraction orders of the pair of complementary diffraction orders.
31. A metrology apparatus as defined in any of clauses 17 to 30, wherein the parameter of interest is overlay or focus.
32. A metrology apparatus as defined in any of clauses 17 to 31, wherein said higher harmonic comprises at least the second harmonic.
33. A method of measurement of a diffractive structure on a substrate, comprising:
   exciting the diffractive structure with first radiation having a first wavelength thereby generating second radiation comprising a second harmonic of said first radiation from said diffractive structure, said second radiation further diffracting from said diffractive structure to form diffracted second radiation;
   detecting at least said diffracted second radiation; and
   determining a parameter of interest relating to said diffractive structure from at least said diffracted second radiation.
34. A method as defined in clause 33, comprising separating said diffracted second radiation from scattered first radiation having been scattered by said diffractive structure.
35. A method as defined in clause 34, comprising using a Berek polarizer with retardation set at *π* for the first wavelength and a polarizing beam splitter to perform said separating, wherein said first radiation is s-polarized or p-polarized first radiation.
36. A method as defined in clause 34 or 35, comprising detecting said scattered first radiation; wherein said determining step comprises determining a pulse shape setting for said first radiation and/or a focus setting from said scattered first radiation.
37. A method as defined in clause 34, 35 or 36, comprising detecting interference between a first order of the first scattered radiation and a second order of the second diffracted radiation; and determining said parameter of interest from said interference.
38. A method as defined clause 34 or 35, comprising filtering out said first scattered radiation.
39. A method as defined in any of clauses 33 to 38, wherein the first radiation comprises pulsed radiation, each pulse being shorter than 0.1ps.
40. A method as defined in clause 39, comprising controlling the chromatic dispersion of the first radiation thereby defining the pulse duration and/or intensity prior to the excitation step.
41. A method as defined in any of clauses 33 to 40, wherein the first radiation comprises broadband or supercontinuum radiation.
42. A method as defined in any of clauses 33 to 41, wherein said diffracted second radiation comprises at least a pair of complementary diffraction orders, and said step of determining said parameter of interest comprises determining the parameter of interest from a difference or imbalance of a parameter between the respective diffraction orders of the pair of complementary diffraction orders.
43. A method as defined in any of clauses 33 to 42, wherein the parameter of interest is overlay or focus.
44. A method of measurement of a diffractive structure on a substrate, comprising:
   exciting the diffractive structure with first radiation having a first wavelength thereby generating second radiation comprising a higher harmonic of said first radiation from said diffractive structure, said second radiation further diffracting from said diffractive structure to form diffracted second radiation;
   separating said diffracted second radiation from scattered first radiation having been scattered by said diffractive structure;
   detecting at least said diffracted second radiation; and
   determining a parameter of interest relating to said diffractive structure from at least said diffracted second radiation.
45. A method as defined in clause 44, comprising using a Berek polarizer with retardation set at *π* for the first wavelength and a polarizing beam splitter to perform said separating, wherein said first radiation is s-polarized or p-polarized first radiation.
46. A method as defined in clause 44 or 45, comprising detecting said scattered first radiation; wherein said determining step comprises determining a pulse shape setting for said first radiation and/or a focus setting from said scattered first radiation.
47. A method as defined in clause 44, 45 or 46, comprising detecting interference between a first order of the first scattered radiation and a second order of the second diffracted radiation; and determining said parameter of interest from said interference.
48. A method as defined clause 44 or 45, comprising filtering out said first scattered radiation.
49. A method as defined in any of clauses 44 to 48, wherein the first radiation comprises pulsed radiation, each pulse being shorter than 0.1ps.
50. A method as defined in clause 49, comprising controlling the chromatic dispersion of the first radiation thereby defining the pulse duration and/or intensity prior to the excitation step.
51. A method as defined in any of clauses 44 to 50, wherein the first radiation comprises broadband or supercontinuum radiation.
52. A method as defined in any of clauses 44 to 51, wherein said diffracted second radiation comprises at least a pair of complementary diffraction orders, and said step of determining said parameter of interest comprises determining the parameter of interest from a difference or imbalance of a parameter between the respective diffraction orders of the pair of complementary diffraction orders.
53. A method as defined in any of clauses 44 to 52, wherein the parameter of interest is overlay or focus.
54. A method as defined in any of clauses 44 to 53, wherein said higher harmonic comprises at least the second harmonic.
55. A lithographic apparatus comprising the metrology apparatus according to clauses 1 to 32.
56. A lithographic cell comprising the metrology apparatus according to clauses 1 to 32.
57. A wavelength separation or filtering arrangement comprising a Berek polarizer and polarizing beam splitter.

The above disclosed concepts may be used in the context of metrology for lithography control, for example to measure one or more of: overlay, focus, critical dimension, and other profilometry parameters.

Although specific reference may be made in this text to the use of lithographic apparatus in the manufacture of ICs, it should be understood that the lithographic apparatus described herein may have other applications. Possible other applications include the manufacture of integrated optical systems, guidance and detection patterns for magnetic domain memories, flat-panel displays, liquid-crystal displays (LCDs), thin-film magnetic heads, etc.

Although specific reference may be made in this text to embodiments in the context of a lithographic apparatus, embodiments may be used in other apparatus. Embodiments may form part of a mask inspection apparatus, a metrology apparatus, or any apparatus that measures or processes an object such as a wafer (or other substrate) or mask (or other patterning device). These apparatuses may be generally referred to as lithographic tools. Such a lithographic tool may use vacuum conditions or ambient (non-vacuum) conditions.

Although specific reference may be made in this text to embodiments in the context of an inspection or metrology apparatus, embodiments may be used in other apparatus. Embodiments may form part of a mask inspection apparatus, a lithographic apparatus, or any apparatus that measures or processes an object such as a wafer (or other substrate or mask (or other patterning device. The term "metrology apparatus" (or "inspection apparatus") may also refer to an inspection apparatus or an inspection system (or a metrology apparatus or a metrology system). E.g. the inspection apparatus that comprises an embodiment may be used to detect defects of a substrate or defects of structures on a substrate. In such an embodiment, a characteristic of interest of the structure on the substrate may relate to defects in the structure, the absence of a specific part of the structure, or the presence of an unwanted structure on the substrate.

Although specific reference may have been made above to the use of embodiments in the context of optical lithography, it will be appreciated that the invention, where the context allows, is not limited to optical lithography and may be used in other applications, for example imprint lithography.

While the targets or target structures (more generally structures on a substrate) described above are metrology target structures specifically designed and formed for the purposes of measurement, in other embodiments, properties of interest may be measured on one or more structures which are functional parts of devices formed on the substrate. Many devices have regular, grating-like structures. The terms structure, target grating and target structure as used herein do not require that the structure has been provided specifically for the measurement being performed. Further, pitch of the metrology targets may be close to the resolution limit of the optical system of the scatterometer or may be smaller, but may be much larger than the dimension of typical non-target structures optionally product structures made by lithographic process in the target portions C. In practice the lines and/or spaces of the overlay gratings within the target structures may be made to include smaller structures similar in dimension to the non-target structures.

While specific embodiments have been described above, it will be appreciated that the invention may be practiced otherwise than as described. The descriptions above are intended to be illustrative, not limiting. Thus it will be apparent to one skilled in the art that modifications may be made to the invention as described without departing from the scope of the claims set out below.

Although specific reference is made to "metrology apparatus / tool / system" or "inspection apparatus / tool / system", these terms may refer to the same or similar types of tools, apparatuses or systems. E.g. the inspection or metrology apparatus that comprises an embodiment of the invention may be used to determine characteristics of structures on a substrate or on a wafer. E.g. the inspection apparatus or metrology apparatus that comprises an embodiment of the invention may be used to detect defects of a substrate or defects of structures on a substrate or on a wafer. In such an embodiment, a characteristic of interest of the structure on the substrate may relate to defects in the structure, the absence of a specific part of the structure, or the presence of an unwanted structure on the substrate or on the wafer.

## Claims

1. A metrology apparatus for measurement of a diffractive structure on a substrate, comprising:
a radiation source operable to provide first radiation for excitation of the diffractive structure, said first radiation having a first wavelength;
a detection arrangement operable to detect at least diffracted second radiation comprising a second harmonic of said first radiation, said diffracted second radiation being generated from said diffractive structure and/or substrate and diffracted by said diffractive structure; and
a processing arrangement operable to determine a parameter of interest relating to said diffractive structure from at least said diffracted second radiation.

2. A metrology apparatus as claimed in claim 1, comprising a wavelength separation or filtering arrangement operable to separate or filter out scattered first radiation from said diffracted second radiation, prior to said detection arrangement, said scattered first radiation having been scattered and/or diffracted from said diffractive structure and having said first wavelength.

3. A metrology apparatus as claimed in claim 2, wherein the wavelength separation or filtering arrangement comprises a Berek polarizer and polarizing beam splitter.

4. A metrology apparatus as claimed in claim 3, wherein the radiation source is operable to provide said first radiation as s-polarized or p-polarized first radiation and said Berek polarizer has a retardation set at *π* for the first wavelength.

5. A metrology apparatus as claimed in claim 3 or 4, wherein the polarizing beam splitter comprises a Glan-Taylor polarizer.

6. A metrology apparatus as claimed in any of claims 2 to 5, wherein said detection arrangement is operable to detect said scattered first radiation, and wherein, optionally, said processing arrangement is operable to determine a pulse shape setting for said first radiation and/or a focus setting from said scattered first radiation.

7. A metrology apparatus as claimed in claim 6, wherein said detection arrangement is operable to detect interference between a first order of the first scattered radiation and a second order of the second diffracted radiation; and said processing arrangement is operable to determine said parameter of interest from said interference.

8. A metrology apparatus as claimed in any of claims 2 to 5, wherein the wavelength separation or filtering arrangement comprises a band-pass or low-pass filter.

9. A metrology apparatus as claimed in any of claims 2 to 5, wherein the wavelength separation or filtering arrangement comprises is effected by said collection optics of said metrology device not collecting said scattered first radiation.

10. A metrology apparatus as claimed in any preceding claim, wherein the radiation source is a pulsed radiation source operable to provide said first radiation as a train of pulses, each pulse being shorter than 0.1ps, and wherein, optionally, the radiation source is a broadband or supercontinuum radiation source.

11. A metrology apparatus as claimed in claim 10, comprising a pulse shaping device between the radiation source and substrate and being operable to control the chromatic dispersion of the first radiation thereby defining the pulse duration and/or intensity.

12. A metrology apparatus as claimed in claim 10 or 11, wherein said radiation source and/or said pulse shaping device provides for tuning of said first wavelength between 1.8µm-300nm.

13. A metrology apparatus as claimed in any preceding claim, wherein said diffracted second radiation comprises at least a pair of complementary diffraction orders, and said processing arrangement is operable to determine said parameter of interest from a difference or imbalance of a parameter between the respective diffraction orders of the pair of complementary diffraction orders.

14. A metrology apparatus as claimed in any preceding claim, wherein the parameter of interest is overlay or focus.

15. A method of measurement of a diffractive structure on a substrate, comprising:
exciting the diffractive structure with first radiation having a first wavelength thereby generating second radiation comprising a second harmonic of said first radiation from said diffractive structure, said second radiation further diffracting from said diffractive structure to form diffracted second radiation;
detecting at least said diffracted second radiation; and
determining a parameter of interest relating to said diffractive structure from at least said diffracted second radiation.
